# EUROPÄISCHE PATENTSCHRIFT

(11) **EP 3 277 504 B1**
(45) Veröffentlichungstag und Bekanntmachung des Hinweises auf die Patenterteilung: **10.04.2019**
(21) Anmeldenummer: 16704626.7
(22) Anmeldetag: 15.02.2016
(51) Int. Cl.: H01R 13/03, H01R 43/16, B29C 64/10, G01R 1/067, G01R 3/00, H01R 13/24, B29C 64/153, H01R 12/71, B33Y 80/00, B33Y 10/00, B33Y 30/00

(54) **VERFAHREN ZUR HERSTELLUNG MINDESTENS EINES FEDERKONTAKTSTIFTS ODER EINER FEDERKONTAKTSTIFT-ANORDNUNG SOWIE ENTSPRECHENDE VORRICHTUNGEN**
METHOD FOR PRODUCING AT LEAST ONE SPRING CONTACT PIN OR A SPRING CONTACT PIN ARRANGEMENT, AND CORRESPONDING DEVICES
PROCÉDÉ DE FABRICATION D'AU MOINS UNE TIGE DE CONTACT À RESSORT OU D'UN ENSEMBLE DE TIGES DE CONTACT À RESSORT ET DISPOSITIFS CORRESPONDANTS

(30) Priorität: 31.03.2015 DE 102015004151
(43) Veröffentlichungstag der Anmeldung: 07.02.2018
(73) Patentinhaber: Feinmetall GmbH, 71083 Herrenberg (DE)
(72) Erfinder: BURGOLD, Jörg, 71083 Herrenberg (DE); KÖNIG, Christian, 70794 Filderstadt (DE); SCHÄFER, Wolfgang, 72661 Grafenberg (DE)
(74) Vertreter: Clarenbach, Carl-Philipp
(86) Internationale Anmeldenummer: PCT/EP2016/053183
(87) Internationale Veröffentlichungsnummer: WO 2016/155936

(56) Entgegenhaltungen:
- EP-A1- 0 232 653
- EP-A2- 0 184 608
- CA-A1- 2 887 694
- "Dip-in Laser Lithografie", , 19. September 2012 (2012-09-19), Seiten 1-1, XP002758114, Gefunden im Internet: URL:http://www.nanoscribe.de/files/1113/87 55/1452/PI_2012_14_Nanoscribe_DiLL_en.pdf [gefunden am 2016-05-27]

## Beschreibung

Die Erfindung betrifft ein Verfahren zur Herstellung einer einer elektrischen Berührungskontaktierung dienenden Federkontaktstift-Anordnung mit mindestens einem Federkontaktstift.

Bei der bisherigen, bekannten Herstellung von Federkontaktstiften erfolgt die Fertigung einzelner Bauteile, wie zum Beispiel Kolben, Feder, Kopf, Mantel und so weiter, mittels spanabhebenden oder umformenden Fertigungsverfahren wie Drehen, Fräsen, Tiefziehen, Schmieden und so weiter. Nach Fertigstellung der einzelnen Bauteile erfolgt deren Montage. Der Durchmesser eines derartigen, bekannten Federkontaktstifts bestimmt das sogenannte Rastermaß (Mittenabstand zu einem Nachbarstift), wobei das Rastermaß vom Prüfling vorgegeben wird, also von einem elektrischen Bauteil, das mittels der Federkontaktstifte elektrisch berührungskontaktiert wird, um Prüfstromkreise herzustellen, die eine Beurteilung der Funktionsfähigkeit des Prüflings ermöglichen. Derzeit sind Federkontaktstifte mit einem minimalen Durchmesser von etwa 0,1 mm mit dem vorstehend genannten, klassischen Aufbau bekannt, wobei derart kleine Durchmesser in dem klassischen Herstellungsverfahren nicht wirtschaftlich in hoher Qualität herstellbar sind. Ein wesentlicher Grund hierfür sind die hohen Anforderungen an die Toleranzen bei der Herstellung der einzelnen Bauteile sowie die anschließende, nur manuell zu bewerkstelligende Montage der einzelnen Bauteile zu einem kompletten Federkontaktstift.

Aus der Offenlegungsschrift EP 0 232 653 A1 ist ein Verfahren zum Herstellen von Kontaktstiften aus Kunststoff mit einer anschließenden Metallisierung bereits bekannt. Ein ähnliches Verfahren ist auch bereits aus der Offenlegungsschrift CA 2 887 694 A1 bekannt. Aus der Veröffentlichung "Dip-in Laser Lithographie" (19. September 2012 (2012-09-19), Seiten 1-1, XP002758114, Gefunden im Internet: URL:http://www.nanoscribe.de/files/1113/8755/1452/PI 2012 14 Na noscribe DiLL en.pdf [gefunden am 2016-05-27]) ist ein Verfahren zur Herstellung von Nano- und Mikrostrukturen bekannt.

Der Erfindung liegt die Aufgabe zugrunde, eine Federkontaktstiftanordnung mit mindestens einem Federkontaktstift der eingangs genannten Art herstellen zu können, die ein sehr kleines Rastermaß gestattet, kostengünstig erstellt werden kann und eine hohe Qualität aufweist und funktionssicher ist.

Diese Aufgabe wird erfindungsgemäß - unter Einbeziehung des eingangs genannten Verfahrens - durch folgende Verfahrensschritte gemäß Anspruch 1 gelöst: Herstellen von mindestens einem Basisteil des Federkontaktstifts, wobei mindestens ein Teil des Basisteils aus Kunststoff hergestellt wird, und anschließend erfolgendem Metallisieren von mindestens dem aus Kunststoff bestehenden Teil des Basisteils. Durch das Metallisieren wird eine metallische Beschichtung/Metallhülle geschaffen, die eine elektrische Leitfähigkeit, vorzugsweise eine gute elektrische Leitfähigkeit besitzt. Durch das erfindungsgemäße Metallisieren von zumindest einem Teil des Basisteils lässt sich ein miniaturisierter Federkontaktstift schaffen, der nur wenige oder gar keine Zusammenbaumontageschritte von Einzelteilen benötigt. Das Basisteil bildet bevorzugt die Grundstruktur des Federkontaktstifts, wobei es zumindest teilweise aus Kunststoff hergestellt wird. Um für die mit dem Federkontaktstift durchzuführende Berührungskontaktierung für eine elektrische Prüfung eines elektrischen Prüflings durchführen zu können, bedarf es einer elektrischen Leitfähigkeit des Federkontaktstifts. Die elektrische Leitfähigkeit wird durch das Metallisieren von mindestens dem aus Kunststoff bestehenden Teil des Basisteils herbeigeführt. Aufgrund des Einsatzes des Kunststoffes können auch komplexe Strukturen einfach und kostengünstig erstellt werden. Nach dem Metallisieren des Kunststoffes sind derart komplexe, elektrisch leitfähige Strukturen geschaffen, die nach dem herkömmlichen Fertigungsverfahren gar nicht oder nur mit extrem hohen Kosten und auch nicht in der durch die Erfindung möglichen Miniaturisierung herstellbar sind. Gute elektrische sowie mechanische Eigenschaften des Federkontaktstifts werden durch das Metallisieren erreicht. Das Kunststoffteil, insbesondere Kunststoffbasisteil, ermöglicht die Realisierung sehr filigraner Strukturen, die jedoch keine hinreichenden elektrischen sowie mechanischen Eigenschaften aufweisen, jedoch durch die Metallisierung diese Eigenschaften in hinreichender, sogar guter Qualität erhalten.

Erfindungsgemäß ist vorgesehen, dass die Herstellung von dem zumindest einen, aus Kunststoff bestehenden Teil des Basisteils mittels additivem Fertigungsverfahren erfolgt. Unter dem "additiven Fertigungsverfahren" das auch als "generatives Fertigungsverfahren" bezeichnet wird, wird eine insbesondere schnelle und kostengünstige Fertigung verstanden, die direkt auf der Basis von rechnerinternen Datenmodellen aus formlosem (zum Beispiel Flüssigkeiten, Pulver, oder ähnliches) oder formneutralem (zum Beispiel bandförmig, drahtförmig und so weiter) Material mittels chemischer und/oder physikalischer Prozesse erfolgt. Obwohl es sich dabei um urformende Verfahren handelt, sind für ein konkretes Ergebnis keine speziellen Werkzeuge erforderlich, die die jeweilige Geometrie des Werkstücks gespeichert haben (zum Beispiel Gussformen).

Als additives Fertigungsverfahren wird bevorzugt eine Zwei-Photonen-Laserlithografie, insbesondere ein Dip-In-Laser-Lithografie Verfahren, eingesetzt (DILL-Technologie). Bevorzugt wird ein flüssiges, insbesondere pastöses, Material verwendet und mittels Laser verfestigt. Das Material wird bevorzugt Lage um Lage aufgebaut, sodass auf diese Art und Weise das aus Kunststoff bestehende Teil hergestellt wird. Durch dieses additive Fertigungsverfahren ist eine sehr hohe Gestaltungsfreiheit für unterschiedlichste Geometrien gegeben, sodass auch sehr komplexe Kunststoffstrukturen realisierbar sind. Durch die DILL-Technologie lassen sich Strukturen im Sub-Mikrometer-Bereich herstellen, wodurch erfindungsgemäße Federkontaktstifte für ein Rastermaß von 0,3 mm oder auch kleiner herstellbar sind. Aufgrund der erfindungsgemäßen Technologie wird auch die Herstellung von Prüfkarten mit Raster unter 80 µm möglich. Für diese Technologie sind keinerlei spezielle Werkzeuge für den Aufbau der Bauteile notwendig.

Das Metallisieren erfolgt bevorzugt in mindestens einem galvanischen und/oder chemischen Prozess. Ein galvanischer Prozess zeichnet sich dadurch aus, dass elektrischer Strom eingesetzt wird; der Prozess des chemischen Abscheidens wird auch "Außenstromlose Metallabscheidung" genannt. In jedem Falle erfolgt ein Metallaufbau auf der erwähnten Kunststoffgeometrie. Bevorzugt wird eine Metallschicht durch den galvanischen und/oder chemischen Prozess abgeschieden. Hierfür eigenen sich insbesondere Metalle wie Kupfer, Silber, Gold sowie Nickel.

Nach einer Weiterbildung der Erfindung ist vorgesehen, dass das gesamte Basisteil aus Kunststoff, bevorzugt mittels des aditiven Fertigungsverfahrens, hergestellt, insbesondere als einstückiges Basisteil hergestellt wird. Derartige Bauteile können unterschiedlichste Funktionen vereinen, auch dann, wenn sie als einstückiges Bauteil erstellt sind. So wird bevorzugt für den Federkontaktstift der der Kontaktierung dienende Köpfe direkt an einem federnden Bereich angebracht. Die Feder kann durch die hohe Gestaltungsfreiheit durch das additive Fertigungsverfahren derart ausgelegt werden, dass sie nicht gestützt werden muss, also keinen zusätzlichen Mantel oder dergleichen benötigt. Hierdurch entfällt auch die Montage von Einzelteilen. Ein einstückiges Basisbauteil, das alle Funktionen eines Federkontaktstifts in sich vereinigt, wird in dem additiven Fertigungsverfahren aus Kunststoff erstellt und nachfolgend metallisiert, sodass auf einfache Weise ein vorzugsweise miniaturisierter Federkontaktstift für Rastermaße kleiner 0,1 mm erstellt wird. Bevorzugt wird das gesamte Basisteil metallisiert, sodass Abdeckschritte, wie Maskierungen oder dergleichen nicht erforderlich sind.

Nach einer Weiterbildung der Erfindung ist vorgesehen, dass vor dem galvanischen Metallisieren eine elektrisch leitfähige Startschicht zumindest auf das aus Kunststoff bestehende Teil des Basisteils aufgebracht oder auf der Oberfläche des Teils erzeugt wird. Sofern ein Kunststoff zum Einsatz gelangt, der elektrisch nicht oder nicht hinreichend leitfähig ist, wird für die galvanische Abscheidung eine elektrisch leitfähige Startschicht benötigt, um einen elektrischen Stromfluss beim Galvanisierungsprozess sicherzustellen. Alternativ kann jedoch auch von vornherein ein elektrisch leitfähiger Kunststoff oder ein elektrisch leitfähig ausgerüstetes Kunststoff-Komposit für die Erzeugung des Basisteils eingesetzt werden.

Bevorzugt ist vorgesehen, dass vor dem insbesondere chemischen Metallisieren eine Keimschicht zumindest auf das aus Kunststoff bestehende Teil des Basisteils aufgebracht wird, insbesondere im Tauch- oder Plasmaverfahren aufgebracht, oder auf der Oberfläche des Teils erzeugt wird. Hierdurch werden "Keime" und/oder "Verankerungsstellen" auf der Oberfläche der entsprechenden Kunststoffgeometrie geschaffen, sodass das Metallisieren erfolgen kann.

Bevorzugt ist vorgesehen, dass nach dem Metallisieren das aus Kunststoff bestehende Teil nicht oder zumindest bereichsweise entfernt wird, insbesondere mittels eines Pyrolyseverfahrens, eines nasschemischen Verfahrens und/oder eines trockenchemischen Verfahrens. Selbstverständlich ist es nach dem Metallisieren möglich, den Kunststoffkern, also das Teil des Basisteils oder das gesamte Basisteil, in der Metallhülle verbleiben zu lassen. Alternativ ist es - wie vorstehend erwähnt - möglich, diesen Kunststoffkern durch ein geeignetes selektives Verfahren aus der Metallhülle zu entfernen. Hierzu bietet sich das erwähnte Pyrolyseverfahren, das nasschemische Verfahren und/oder das trockenchemische Verfahren an.

Insbesondere ist vorgesehen, dass in einer durch das Metallisieren gebildeten Metallhülle mindestens eine Öffnung erzeugt oder belassen wird, die zum Entweichen von Pyrolyseprodukten dient und/oder einen Zugriff von mindestens einem nass- und/oder trockenchemischen Mittel beim Durchführen des nasschemischen und/oder trockenchemischen Verfahrens bietet. Damit können die entsprechenden Restprodukte entweichen und/oder es ist eine Zugänglichkeit zu dem zu entfernenden Kunststoffmaterial geschaffen.

Gemäß einer Weiterbildung der Erfindung ist vorgesehen, dass für die Federfunktion des Federkontaktstifts mindestens ein Bereich des Federkontaktstifts durch Eigenelastizität und/oder Formgebung seines Materials federnd nachgiebig ausgebildet wird. Der erfindungsgemäße Federkontaktstift weist demzufolge vorzugsweise kein separates Federbauteil auf, das die Federfunktion herbeiführt, sondern ein Bereich des Federkontaktstifts übernimmt diese Funktion, indem die Eigenelastizität und/oder Formgebung des Materials dieses Bereichs die Federeigenschaften schafft.

Insbesondere ist der federnde Bereich einstückig mit dem übrigen Abschnitt des Federkontaktstifts ausgebildet, d.h., es liegt ein einstückiger Federkontaktstift vor, von dem ein Bereich federnd wirkt. Unter dem "einstückigen Federkontaktstift" soll auch ein Federkontaktstift verstanden werden, der aus dem durch die Metallisierung gebildeten Bauteil besteht, unabhängig davon, ob sich der Kunststoffkern noch in der Metallhülle befindet oder ob der Kunststoffkern entfernt oder zumindest teilweise entfernt wurde.

Bevorzugt kann der federnde Bereich durch Ausbildung mindestens einer Druck-, Zug-, Biege- und/oder Torsionsfeder und/oder als nach dem Knickdraht-Prinzip nachgiebiger Bereich hergestellt werden. Diese erwähnte Feder ist bevorzugt einstückig mit dem übrigen Abschnitt des Federkontaktstifts ausgebildet. Beim "Knickdraht-Prinzip" ist vorgesehen, dass der entlang seiner Längserstreckung auf Druck bei der Berührungskontaktierung des Prüflings beanspruchte Federkontaktstift seitlich ausfedert.

Eine Weiterbildung der Erfindung sieht vor, dass endseitig am Federkontaktstift mindestens ein Kopf für die Berührungskontaktierung ausgebildet wird, der vorzugsweise mindestens eine scharfe Spitze und/oder scharfe Kante für die Berührungskontaktierung erhält. Bevorzugt ist an jedem Ende des Federkontaktstifts ein derartiger Kopf ausgebildet. Die erwähnte scharfe Spitze und/oder Kante wird bevorzugt durch das Kunststoff-Basisteil erzeugt und durch die nachfolgende Metallisierung elektrisch leitfähig und hinreichend standfest gemacht.

Die in dieser Patentanmeldung beschriebenen Anordnungen, die nicht nur einen oder mehrere Federkontaktstifte umfassen, sondern auch zusätzliche Teile, werden jeweils als "Federkontaktstift-Anordnung mit mindestens einem Federkontaktstift" bezeichnet.

Nach einer Weiterbildung der Erfindung ist vorgesehen, dass der Federkontaktstift mit mindestens einem entfernbaren, insbesondere abtrennbaren Verbindungsteil versehen wird. Dieses Verbindungsteil dient insbesondere der Handhabung/Manipulation des Federkontaktstifts, um ihn bei einer Montage besser handeln zu können, beispielsweise in einen Prüfadapter einbringen zu können. Ist das Handling abgeschlossen, so wird bevorzugt das Verbindungsteil entfernt, beispielsweise abgetrennt, was beispielsweise durch eine Sollbruchstelle begünstigt oder durch einen weiteren Prozessschritt erfolgen kann. Für einen solchen Prozessschritt bietet sich zum Beispiel ein Laser-Trennverfahren oder ein fokussierendes ionenstrahlbasiertes Trennverfahren an.

Nach einer Weiterbildung der Erfindung kann vorgesehen sein, dass mehrere Federkontaktstifte - insbesondere in einem zwei- oder dreidimensionalen Raster - über das mindestens eine Verbindungsteil zusammenhängend hergestellt werden. So sind diese Federkontaktstifte beispielsweise schon in dem gewünschten Rastermaß angeordnet und insbesondere auch als gemeinsame Einheit zu handhaben, wobei die Handhabung nicht nur manuell, sondern auch maschinell oder als kombiniertes manuelles und maschinelles Handhaben erfolgen kann.

Eine Weiterbildung der Erfindung sieht vor, dass das Verbindungsteil als Verbindungssteg oder Verbindungsplatte, insbesondere Führungsplatte, ausgebildet ist. Weist der Federkontaktstift den Verbindungssteg auf, so kann hierüber das Handling erfolgen, beispielsweise im Metallisierungsprozess und/oder für eine bessere Konfektionierung und/oder bei einer Montage, beispielsweise in einen Prüfadapter. Verbindet der Verbindungssteg mehrere Federkontaktstifte, so lässt sich die Gruppe der Federkontaktstifte dadurch sehr gut handhaben. Bei einer Verbindungsplatte lassen sich mehrere Federkontaktstifte dreidimensional anordnen, d.h., sie werden von der Platte in einem dreidimensionalen Raster gehalten und sind hierdurch sehr gut als Gruppe zusammenhängend zu handhaben. Handelt es sich bei dem Verbindungsteil um eine Führungsplatte, so kann diese mit Führungsbohrungen versehen sein, die von Federkontaktstiften durchgriffen werden. Bei der Handhabung sind die Federkontaktstifte mit den Bohrungswandungen zumindest bereichsweise verbunden. Diese jeweilige Verbindung kann später beseitigt werden, sodass die Führungsbohrungen zur Axialführung der Federkontaktstifte beim Berührungskontaktieren dienen. Insbesondere können mehrere derartige Führungsplatten vorgesehen sein, insbesondere zwei Führungsplatten, die beabstandet zueinander liegen und hierdurch die Federkontaktstifte optimal halten, positionieren und führen.

Insbesondere ist vorgesehen, dass das Verbindungsteil im additiven Fertigungsverfahren erzeugt oder miterzeugt wird. Alternativ ist es jedoch auch möglich, dass das Verbindungsteil als vorgefertigtes Zuführteil eingesetzt wird, d.h., es wird dem additiven Fertigungsverfahren zur Herstellung des mindestens einen Federkontaktstifts vorgefertigt zugeführt.

Erfindungsgemäß ist vorgesehen, dass das Verbindungsteil ein elektrischer Schaltungsträger, insbesondere eine Leiterplatte ist. Der Schaltungsträger, insbesondere die Leiterplatte, kann elektrische/elektronische Einrichtungen aufweisen, sodass der mindestens eine Federkontaktstift an einer elektrischen/elektronischen Schaltungsanordnung platziert ist.

Erfindungsgemäß ist vorgesehen, dass der mindestens eine Federkontaktstift auf einer elektrischen Kontaktfläche des Verbindungsteils erzeugt wird. Das Verbindungsteil und die elektrische Kontaktfläche werden bei der Berührungskontaktierung genutzt, d.h., der Federkontaktstift wird auf einem Bauteil erzeugt, das später bei der Verwendung des Federkontaktstifts zur Durchführung einer elektrischen Prüfung eines Prüflings weiterhin genutzt wird.

Insbesondere kann die elektrische Kontaktfläche mit metallisiert werden. Die Metallisierung wird somit nicht nur am Basisteil, sondern auch an der elektrischen Kontaktfläche des Verbindungsteils durchgeführt, insbesondere gemeinsam durchgeführt.

Ferner ist es vorteilhaft, wenn auf der Kontaktfläche des Verbindungsteils ein Sockelbauteil aus elektrisch leitfähigem Material, vorzugsweise Metall, hergestellt/befestigt wird und dass auf dem Sockelbauteil der Federkontaktstift hergestellt wird, wobei das Metallisieren sich bis auf einen an das Basisteil angrenzenden Bereich des Sockelbauteils erstreckend erfolgt, jedoch nicht sich bis auf die Kontaktfläche erstreckend erfolgt. Durch das Sockelbauteil wird verhindert, dass sich beim Metallisieren eine metallische Beschichtung bis auf das Verbindungsteil, beispielsweise eine Verbindungsplatte, insbesondere eine Führungsplatte, erstreckt und hierdurch elektrische Kurzschlüsse zwischen benachbarten Federkontaktstiften entstehen. Dadurch, dass sich die Metallisierung bis auf das Sockelbauteil erstreckt, nicht jedoch soweit, dass es sehr nahe an die Kontaktfläche kommt, wird ein derartiger elektrischer Kurzschluss verhindert.

Es ist vorteilhaft, wenn das Sockelbauteil im additiven Fertigungsverfahren, insbesondere durch Sintern, vorzugsweise Lasersintern, von Pulverwerkstoffen, hergestellt wird. Bevorzugt kann die Herstellung des Sockelbauteils auf der Kontaktfläche und insbesondere mit dieser elektrisch verbindend erfolgen. Die Erstellung des Sockelbauteils im Sinterprozess führt vorzugsweise dazu, dass eine elektrische Verbindung mit der Kontaktfläche bei der Herstellung des Sockelbauteils geschaffen wird, wodurch für die elektrische Berührungskontaktierung zur Prüfung des Prüflings gleichzeitig ein entsprechender Abschnitt des zugehörigen Prüfstromwegs mit erstellt wird.

Ferner ist es vorteilhaft, wenn das Sockelbauteil mit mindestens einer federnden Struktur, insbesondere einem federnden Bereich des insbesondere einstückigen Sockelbauteils, derart hergestellt wird, dass die Federwirkung in Richtung der Berührungskontaktierung wirksam ist. Damit wirkt das Sockelbauteil federnd bei der Berührungskontaktierung und kann sich mit der Federwirkung des Federkontaktstifts ergänzen. Insbesondere können die Federstrukturen von Sockelbauteil und Federkontaktstift unterschiedliche Federkonstanten aufweisen. Auch ist es denkbar, den Federkontaktstift aufgrund des federnden Bereichs des Sockelbauteils lediglich als axiale Kurzstruktur auszubilden, im Wesentlichen nur in Form eines federnden Kontaktkopfs.

Weitere Ausgestaltungen und/oder Vorteile der Erfindung ergeben sich aus den Ansprüchen, insbesondere Unteransprüchen.
Die Zeichnungen veranschaulichen die Erfindung anhand von Ausführungsbeispielen und zwar zeigt:
- Figur 1: einen schematischen Aufbau einer 3D-Laserlithogrfie-Anlage zur Herstellung mindestens eines Teils eines Federkontaktstifts oder einer Federkontaktstift-Anordnung,
- Figur 2: einen schematischen Aufbau einer Galvanikanlage zum Metallisieren von mindestens einem Teil des Federkontaktstifts oder der Federkontaktstift-Anordnung,
- Figur 3: ein Basisteil aus Kunststoff für einen Federkontaktstift,
- Figur 4: einen Federkontaktstift, aufweisend das Basisteil der Figur 3, das metallisiert wurde,
- Figur 5: eine weitere Ausführungsform eines Federkontaktstifts in nicht kontaktiertem Zustand,
- Figur 6: den Federkontaktstift der Figur 5 im kontaktierten Zustand,
- Figur 7: ein Ausführungsbeispiel eines Federkontaktstifts, der zum Handhaben mit einem vorzugsweise entfernbaren Verbindungsteil versehen ist,
- Figur 8: mehrere Federkontaktstifte, die mit einem als Führungsplatte ausgebildeten Verbindungsteil verbunden sind,
- Figur 9: mehrere Federkontaktstifte, die mit elektrisch leitfähigen Kontaktflächen (Kontaktpads) eines Verbindungsteils elektrisch leitend verbunden sind, wobei das Verbindungsteil als elektrischer Schaltungsträger, insbesondere als Leiterplatte, ausgebildet ist,
- Figur 10: ein weiteres Ausführungsbeispiel eines Federkontaktstifts mit eine Kontaktfläche aufweisendem Verbindungsteil im noch nicht metallisierten Zustand,
- Figur 11: die Anordnung der Figur 10, nunmehr jedoch metallisiert,
- Figur 12: eine Längsschnittansicht durch den unteren Bereich der Anordnung der Figur 11,
- Figur 13: ein weiteres Ausführungsbeispiel eines Federkontaktstifts mit einem eine Kontaktfläche aufweisenden Verbindungsteil, wobei zwischen der Kontaktfläche und dem Federkontaktstift ein Sockelbauteil angeordnet ist, insgesamt im noch nicht metallisierten Zustand,
- Figur 14: die Anordnung der Figur 13 im metallisierten Zustand,
- Figur 15: ein weiteres Ausführungsbeispiel eines Federkontaktstifts mit Kontaktfläche und Verbindungsteil,
- Figur 16: ein weiteres Ausführungsbeispiel eines Federkontaktstifts,
- Figur 17: eine weiteres Ausführungsbeispiel eines Federkontaktstifts,
- Figur 18: ein weiteres Ausführungsbeispiel eines Federkontaktstifts,
- Figur 19: ein weiteres Ausführungsbeispiel eines Federkontaktstifts,
- Figur 20: verschiedene Ausführungsbeispiele von Köpfen von Federkontaktstiften,
- Figur 21: ein Ausführungsbeispiel eines Kopfs eines Federkontaktstifts,
- Figur 22: ein weiteres Ausführungsbeispiel eines Kopfs eines Federkontaktstifts,
- Figur 23: ein Federkontaktstift oder ein Abschnitt eines Federkontaktstifts mit Schaltkontakt, dargestellt im nicht geschalteten Zustand,
- Figur 24: die Anordnung der Figur 23 im geschalteten Zustand,
- Figur 25: ein Diagramm betreffend die Anordnung der Figuren 23 und 24 und
- Figur 26: ein gegenüber der Figur 9 anderes Ausführungsbeispiel mit mehreren Federkontaktstiften und einem Verbindungsteil.

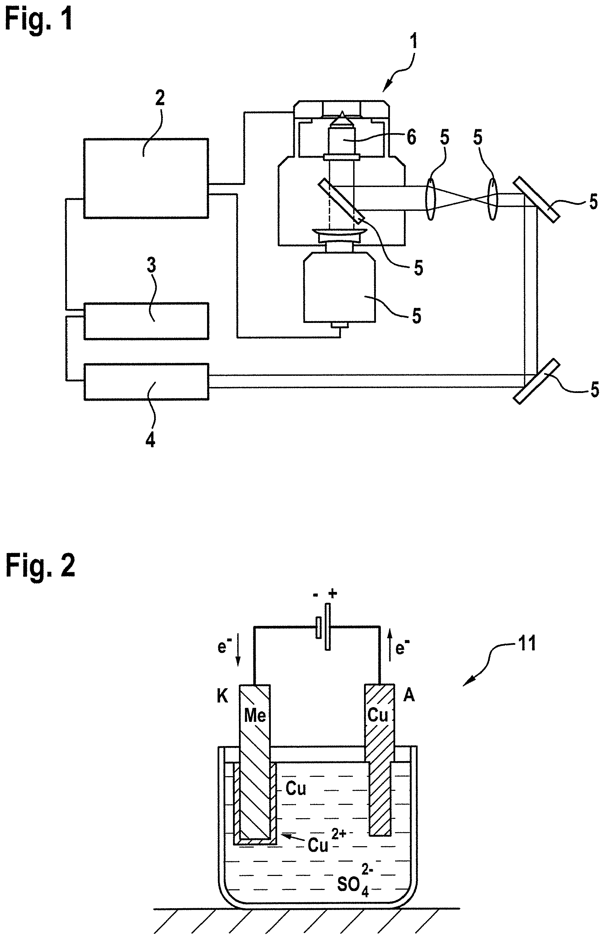

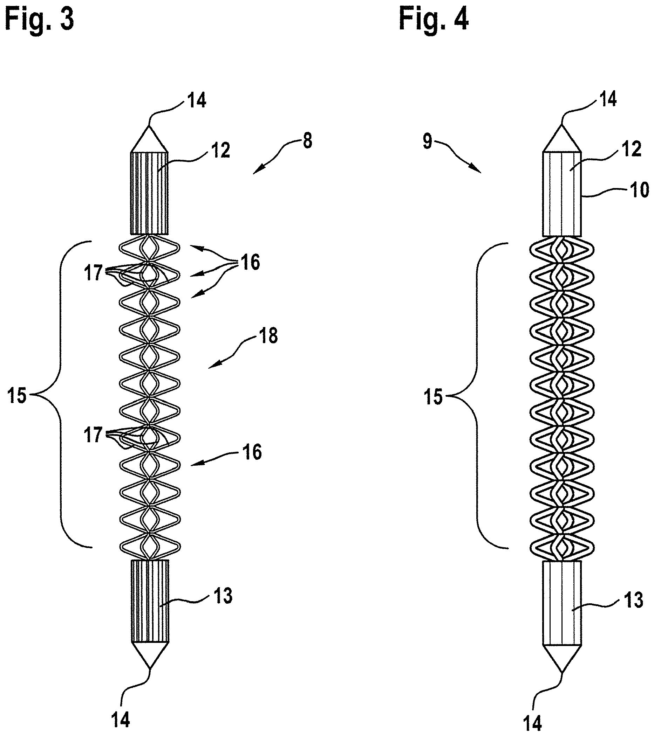

Gemäß Figur 1 wird zur Herstellung mindestens eines, einer elektrischen Berührungskontaktierung dienenden Federkontaktstifts oder einer Federkontaktstift-Anordnung mit mindestens einem derartigen Federkontaktstift, ein additives Fertigungsverfahren eingesetzt. Das additive Fertigungsverfahren bedient sich vorzugsweise einer Dip-In-Laserlithografie (DILL) Technologie, die gemäß Figur 1 eine Werkstückhalteanordnung 1, einen Computer 2, ein Lasersteuergerät 3, einen Laser 4, eine Laserstrahlumlenk-/-fokusierungs-/ und - beeinflussungseinrichtung 5 sowie ein Objektiv 6 umfasst. Ein der Werkstückhalteanordnung 1 zugeordneter Werkstoff, insbesondere in Form einer Flüssigkeit oder einer pastösen Masse, wird - gesteuert vom Computer 2 und der erwähnten Laseranordnung - vernetzt, wodurch das Werkstück entsteht. Die Vernetzung erfolgt Lage um Lage, d.h., das Werkstück wird nach und nach aufgebaut, wobei eine extrem hohe Gestaltungsfreiheit für unterschiedlichste Geometrien besteht. Im vorliegenden Fall wird ein Werkstoff verwendet, der die Herstellung eines Basisteils 8 aus Kunststoff ermöglicht. Das Basisteil 8 (Figur 3) bildet bevorzugt eine Grundstruktur eines Federkontaktstifts 9. Im Einzelnen wird auf den Federkontaktstift 9 der Figur 3 und 4 nachstehend noch näher eingegangen.

Ist das Basisteil 8 gemäß Figur 3 mittels der Anordnung der Figur 1 erstellt, so wird in einem Folgeschritt eine Metallisierung des Basisteils 8 durchgeführt, d.h., der Kunststoff des Basisteils 8 wird mit einer metallischen Beschichtung 10 versehen. Dies erfolgt beispielsweise in einem galvanischen Prozess. Im Ausführungsbeispiel der Figur 2 ist eine Galvanikanlage 11 schematisch dargestellt, bei der von einer Anode A Kupfer in einem Flüssigkeitsbad auf einer Kathode K abgeschieden wird, d.h., die Kathode K erhält einen Überzug aus Kupfer. Wird das Basisteil 8 als Kathode verwendet, so wird es mit einer metallischen Beschichtung 10 aus Kupfer überzogen. Natürlich können auch andere Metalle verwendet werden, insbesondere auch Silber, Gold sowie Nickel und natürlich auch weitere vorteilhafte elektrisch leitfähige Metalle. Um das galvanische Metallisieren des aus Kunststoff bestehenden Basisteils 8 in der Galvanikanlage 11 durchführen zu können, ist eine elektrische Leitfähigkeit des Kunststoffs erforderlich, die mittels einer elektrisch leitfähigen Startschicht herbeigeführt wird. Diese Startschicht wird auf das Basisteil 8 aufgebracht und ermöglicht aufgrund ihrer elektrischen Leitfähigkeit die Abscheidung der metallischen Beschichtung 10. Derartige Startschichten sind grundsätzlich bekannt.

Die Figuren 3 und 4 verdeutlichen das Herstellungsverfahren des Federkontaktstifts 9. Unabhängig von der konkreten Formgebung des Federkontaktstifts 9 wird insbesondere mittels des erwähnten additiven Fertigungsverfahrens das Basisteil 8 der Figur 3 hergestellt. Es weist endseitig jeweils einen Kopf 12, 13, bevorzugt jeweils mit scharfer Spitze 14, auf sowie einen Bereich 15, der als federnder Bereich 15 insbesondere bezüglich seiner Formgebung ausgebildet ist. Das Basisteil 8 ist einstückig ausgebildet, also die beiden Köpfe 12 und 13 sowie der federnde Bereich 15 bestehen aus einstückig zusammenhängendem Kunststoff. Der federnde Bereich 15 setzt sich aus einzelnen tellerfederartigen Federelementen 16 zusammen, die einstückig aneinanderhängen und jeweils mehrere, bogenförmige Arme 17 aufweisen. Insgesamt bildet der federnde Bereich 15 eine in axialer Richtung wirkende Druckfeder 18.

Ein Vergleich der Figuren 3 und 4 zeigt, dass die Grundstruktur des Kunststoffteils der Figur 3 grundsätzlich erhalten bleibt, wenn auf das Basisteil 8 die metallische Beschichtung 10 aufgebracht ist. Je nach verwendetem, elektrisch leitfähigem Metall ergeben sich entsprechende elektrische als auch mechanische Eigenschaften des dann fertigen, aus der Figur 4 hervorgehenden Federkontaktstifts 9. Insbesondere ist vorgesehen, dass die metallische Beschichtung 10 auf der Oberfläche des aus Kunststoff bestehenden Basisteils 8 gebildet wird, weil hier auch die höchsten Spannungen bei mechanischer Belastung erwartet werden. Der Federkontaktstift 9 der Figur 4 kann ein aus Kunststoff bestehendes Basisteil 8 der Figur 3 mit nur einem sehr geringen Volumen aufweisen (zum Beispiel 5,19E-04mm³ bei einer Höhe von 2 mm und einem maximalen Durchmesser von 0,3 mm). Der fertig metallisch beschichtete Federkontaktstift 9 der Figur 4 ist bevorzugt mit einer Schichtdicke von 0,01 mm der metallischen Beschichtung 10 versehen.

Nach der Metallisierung bestehen zwei Möglichkeiten. Der Kunststoffkern (Basisteil 8) verbleibt in der Metallhülle (metallische Beschichtung 10) oder der Kunststoffkern wird durch ein geeignetes Verfahren aus der Metallhülle entfernt, beispielsweise durch Pyrolysierung, durch ein nasschemisches Verfahren oder ein trockenchemisches Verfahren. Besonders bevorzugt ist, wenn die metallische Beschichtung 10 hierfür mindestens eine Öffnung aufweist, sodass Pyrolyseprodukte entweichen können und/oder die nasschemischen oder trockenchemischen Mittel den Kunststoffkern angreifen können.

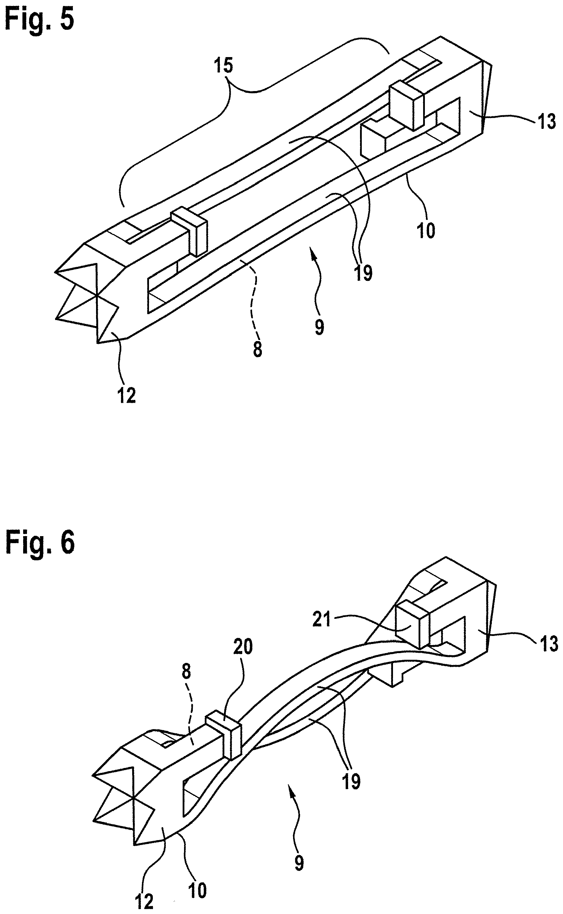

Die Figur 5 zeigt ein weiteres Ausführungsbeispiel eines Federkontaktstifts 9, der nach dem erfindungsgemäßen Verfahren hergestellt wurde. Zwischen den Köpfen 12 und 13 liegen - als federnder Bereich 15 - zwei leicht vorgebogen verlaufende Knickstege 19, die bei einer Berührungskontaktierung, also einem Prüfverfahren, bei dem ein elektrischer Prüfling auf Funktionsfähigkeit geprüft und hierzu mittels des mindestens einen Federkontaktstifts 9 elektrisch kontaktiert wird, seitlich ausbiegen (Knickdrahtprinzip). Um dieses seitliche Ausbiegen zu begrenzen, gehen von den Köpfen 12 und 13 gemäß Figur 6 Anschläge 20, 21 aus, gegen die die Knickstege 19 bei entsprechend großer axialer Belastung des Federkontaktstifts 9 treten.

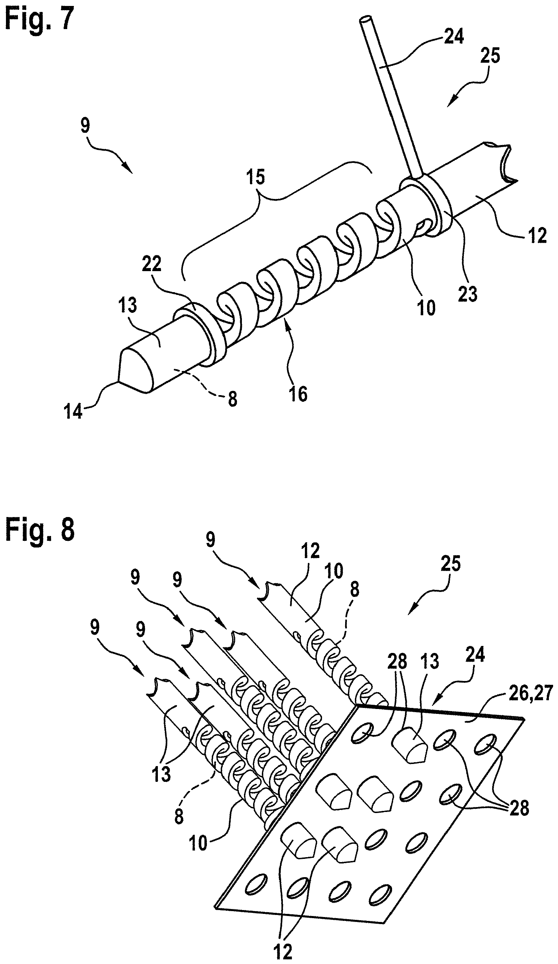

Die Figur 7 zeigt ein weiteres Ausführungsbeispiel eines Federkontaktstifts 9, der ebenfalls nach dem befindungsgemäßen Verfahren hergestellt ist, also ein aus Kunststoff bestehendes Basisteil 8 aufweist, das mit einer metallischen Beschichtung 10 versehen wurde. Zwischen den beiden Köpfen 12 und 13 des Federkontaktstifts 9 liegt der federnde Bereich 15, der im vorliegenden Falle als Spiraldruckfeder ausgebildet ist. Wie auch bei den vorhergehenden Ausführungsbeispielen ist der Federkontaktstift 9 einstückig ausgebildet, wobei diese Definition unabhängig davon gelten soll, ob er noch den Kunststoffkern aufweist oder nicht. Um den axialen Federweg zu begrenzen, können ringförmig gestaltete Anschläge 22, 23, jeweils am Ende des federnden Bereichs 15 vorgesehen sein. Im in einen Prüfadapter oder dergleichen eingebauten Zustand des Federkontaktstifts 9 wirken die Anschläge 22 und 23 mit entsprechenden Führungsplatten des Prüfadapters zusammen. Der Federkontaktstift 9 durchsetzt Bohrungen der Führungsplatten, wobei sich die Anschläge 22 und 23 zwischen den Führungsplatten befinden. Die Anordnung ist derart getroffen, dass der Federkontaktstift 9 im eingebauten Zustand und durch die Abstützung der Anschläge 22 und 23 an den Führungsplatten leicht vorgespannt, das heißt axial komprimiert ist. Beim Ausführungsbeispiel der Figur 7 ist die Besonderheit vorgesehen, dass der Federkontaktstift 9 mit einem entfernbaren Verbindungsteil 24 versehen ist. Das Verbindungsteil 24 ist dort als Verbindungssteg ausgebildet. Das Verbindungsteil 24 wird bevorzugt im Zuge des erwähnten additiven Fertigungsverfahrens, also bei der Herstellung des Basisteils 8, miterstellt oder als fertiges Zuführteil dem Prozess zugeführt und dabei mit dem Basisteil 8 verbunden oder es wird in einem separaten, weiteren additiven Fertigungsverfahren hergestellt, insbesondere dabei am Basisteil 8 befestigt, wobei dieses weitere additive Fertigungsverfahren vorzugsweise ein Sinterverfahren, insbesondere ein Lasersinterverfahren ist, bei dem Pulverwerkstoffe eingesetzt und durch das Sintern, insbesondere Lasersintern, vernetzt werden, sodass dadurch das Verbindungsteil 24 entsteht. Bei der Metallisierung kann vorgesehen sein, dass das Verbindungsteil 24 nicht mit metallisiert wird oder es wird ebenfalls metallisiert. Das Verbindungsteil 24 dient insbesondere der einfacheren Handhabung des Federkontaktstifts 9, insbesondere einer einfacheren Handhabung des Basisteils 8 für den Metallisierungsprozess und/oder bei dem späteren Einsatz des fertigen Federkontaktstifts 9, beispielsweise um ihn in einen Prüfadapter einfach einbringen zu können. Insbesondere ist vorgesehen, dass bei dem Ausführungsbeispiel der Figur 7 das Verbindungsteil 24 nach Abschluss der entsprechenden Handhabung entfernt wird, beispielsweise durch Abbrechen, vorzugsweise an einer Sollbruchstelle oder durch Laserabtrennung und so weiter. Beim Ausführungsbeispiel der Figur 7 liegt insgesamt eine Federkontaktstift-Anordnung 25 vor, nämlich ein Federkontaktstift 9 sowie das daran angeordnete Verbindungsteil 24.

Die Figur 8 zeigt eine weitere Federkontaktstift-Anordnung 25, nämlich ein Verbindungsteil 24, an dem mehrere Federkontaktstifte 9 angeordnet sind. Die Federkontaktstifte 9 sind erfindungsgemäß hergestellt. Das Verbindungsteil 24 ist als Verbindungsplatte 26, insbesondere als Führungsplatte 27 ausgebildet. Die Führungsplatte 27 kann im additiven Fertigungsverfahren - ebenso wie die Basisteile 8 der Federkontaktstifte 9 hergestellt sein oder als fertiges Zuführteil oder als in einem weiteren additiven Fertigungsverfahren hergestelltes Teil. Gemäß Figur 8 weist die Führungsplatte 27 in einem Raster, insbesondere zweidimensionalen Raster, angeordnete Führungslöcher 28 auf, von denen zumindest einige von Federkontaktstift 9, insbesondere im Bereich einer ihrer Köpfe 12, 13 durchsetzt werden. Die Führungsplatte 27 hat die Funktion, die einzelnen Federkontaktstifte 9 aufzunehmen und auf das angestrebte Raster und Design, insbesondere des Prüfadapters, auszurichten. Die Federkontaktstifte 9 werden in den Führungslöchern 28 axial geführt, also in Position gehalten und es wird nur die Bewegungsfreiheit des axialen Einfederns zugelassen, insbesondere des axialen Einfederns eines oder beider Köpfe 12, 13. Das Verbindungsteil 24, also insbesondere die Führungsplatte 27, kann - wie erwähnt - in dem additiven Prozess bei der Herstellung der Federkontaktstifte 9 mit hergestellt werden. Da das Verbindungsteil 24 jedoch eine relativ große Struktur darstellt und ein entsprechend großes Volumen besitzt, bietet es sich bevorzugt an, dieses Bauteil als Einlegeteil dem additiven Prozess zuzuführen. Die Federkontaktstifte 9 werden dann direkt auf Oberflächen des Verbindungsteils 24 aufgebaut, insbesondere innerhalb der Führungslöcher 28. Sollten dabei elektrische und/oder mechanische Verbindungen zwischen den Federkontaktstiften 9 und dem Verbindungsteil 24 entstehen, so können diese später wieder aufgetrennt werden. Durch die Führungsplatte 27 ist es möglich, die Federkontaktstifte 9 direkt in der richtigen Anordnung für die spätere Prüfanwendung herzustellen. Ferner besteht der Vorteil, dass selbst die Montage der Federkontaktstifte 9 in das Verbindungsteil 24, insbesondere die Führungsplatte 27, entfällt. Sind bei der Herstellung die aus Kunststoff bestehenden Basisteile 8 der Federkontaktstifte 9 am Verbindungsteil 24 hergestellt, so ist bei der nachfolgenden Metallisierung sicherzustellen, dass nur die einzelnen Basisteile 8, nicht jedoch das Verbindungsteil 24 eine metallische Beschichtung 10 erhält, um elektrische Kurzschlüsse zu vermeiden. Hierzu ist es beispielsweise möglich, das Verbindungsteil 24 aus einem Material aufzubauen oder zuzuführen, dass im Gegensatz zu dem Kunststoff der Basisteile 8 sich nicht galvanisch oder chemisch metallisch beschichten lässt. Als Material für das Verbindungsteil 24 kann beispielsweise Keramik eingesetzt werden. Denkbar ist auch, dass eine eventuelle metallische Beschichtung 10 des Verbindungsteils 24 in einem nachgeschalteten Prozess wieder entfernt wird. Dies könnte insbesondere durch eine anschließende Laserbearbeitung erfolgen, welche die metallische Beschichtung 10 im Bereich des Verbindungsteils 24 wieder entfernt. Auch ist es denkbar, Maskierungsprozesse einzusetzen, welche insbesondere vor dem Prozess des Aufbringens der Startschicht im galvanischen Prozess oder einer Bekeimung bei einem chemischen Prozess durchgeführt werden. Die metallische Beschichtung 10 würde dann gegebenenfalls auch auf der Maskierung stattfinden. Die metallische Beschichtung 10 würde dann zusammen mit der Maskierung in einem sogenannten Lift-Off-Prozess entfernt werden.

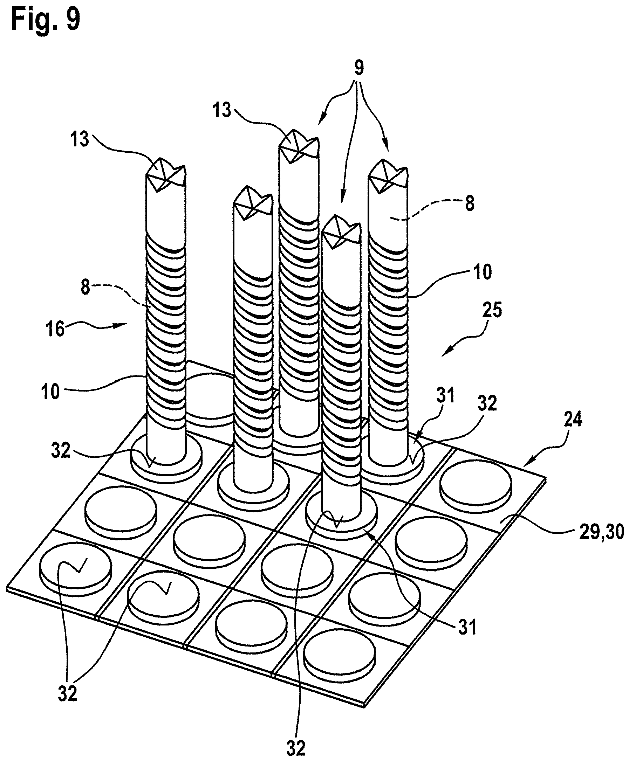

Die Figur 9 zeigt ein weiteres Ausführungsbeispiel einer Federkontaktstift-Anordnung 25 mit mehreren Federkontaktstiften 9, die nach dem erfindungsgemäßen Verfahren hergestellt wurden. Ferner weist die Federkontaktstift-Anordnung 25 ein Verbindungsteil 24 auf, das als elektrischer Schaltungsträger 29, insbesondere Leiterplatte 30, ausgebildet ist. Im Gegensatz zum Ausführungsbeispiel der Figur 8 weist das Verbindungsteil 24 der Figur 9 nicht nur eine mechanische, sondern auch eine elektrische Funktion auf (beim Ausführungsbeispiel der Figur 8 ist es eine rein mechanische Funktion, nämlich eine Ausricht-, Halte- und Führungsfunktion). Beim Ausführungsbeispiel der Figur 9 wird eine elektrische Schnittstelle 31 bei jedem der Federkontaktstifte 9 realisiert. Bei der Schnittstelle 31 handelt es sich jeweils um ein zusätzliches Bauteil, das sowohl eine mechanische Fixierung des jeweiligen Federkontaktstifts 9 am Verbindungsteil 24 übernimmt, als auch deren einzelne elektrische Kontaktierung. Die Federkontaktstifte 9 werden vorzugsweise mit dem erfindungsgemäßen Verfahren direkt auf elektrische Kontaktflächen 32, die sich auf dem elektrischen Schaltungsträger 29 befinden, additiv aufgebaut. Bei der Metallisierung der Basisteile 8 der Federkontaktstifte 9 wird eine elektrische Verbindung zwischen der metallischen Beschichtung 10 und der elektrischen Kontaktfläche 32 geschaffen, sodass eine nicht lösbare, elektrische Verbindung zwischen dem jeweiligen Federkontaktstift 9 und dem elektrischen Schaltungsträger 29 besteht. Diese elektrische Verbindung besteht natürlich nicht zwischen den einzelnen elektrischen Kontaktflächen 32, da dies zu Kurzschlüssen führen würde. Auch dieser Systemaufbau zeigt, dass eine Montage und Justage einzelner Federkontaktstifte an einem Schaltungsträger gemäß Stand der Technik entfällt. Durch die Erfindung liegt eine hochintegrierte, einfache Lösung vor. Eine Kontaktierung eines Prüflings erfolgt insbesondere durch Zuführen der nicht mit dem elektrischen Schaltungsträger 29 verbundenen Enden der Federkontaktstifte 9 auf entsprechende Kontakte des zu prüfenden elektrischen Prüflings. Wie bereits beim Ausführungsbeispiel der Figur 8 erwähnt, kann das Verbindungsteil 24 der Figur 9 ebenfalls auf drei verschiedene Arten realisiert werden, entweder wird es mit aufgebaut bei der Herstellung der Federkontaktstifte 9 im additiven Fertigungsprozess oder es wird als Zuführteil zugeführt oder es wird in einem anderen additiven Fertigungsverfahren, insbesondere Sintern von Pulverwerkstoffen, erzeugt. Die aus leitfähigem Material, insbesondere Metall bestehenden elektrischen Kontaktflächen 32 können dabei entweder als fertige Teile zugeführt oder durch entsprechende metallische Beschichtung auf der Oberfläche des Verbindungsteils 24 realisiert werden.

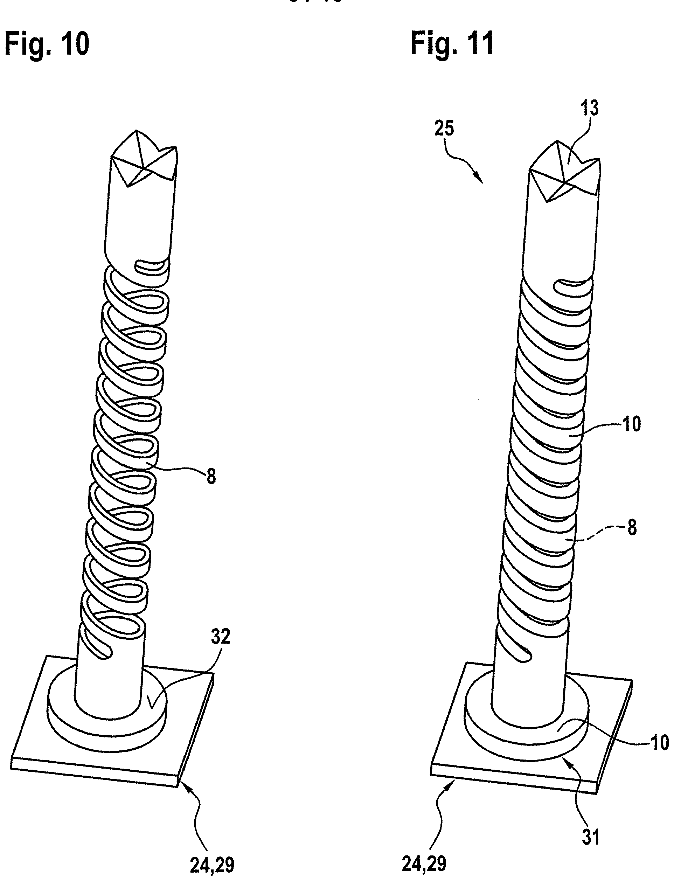

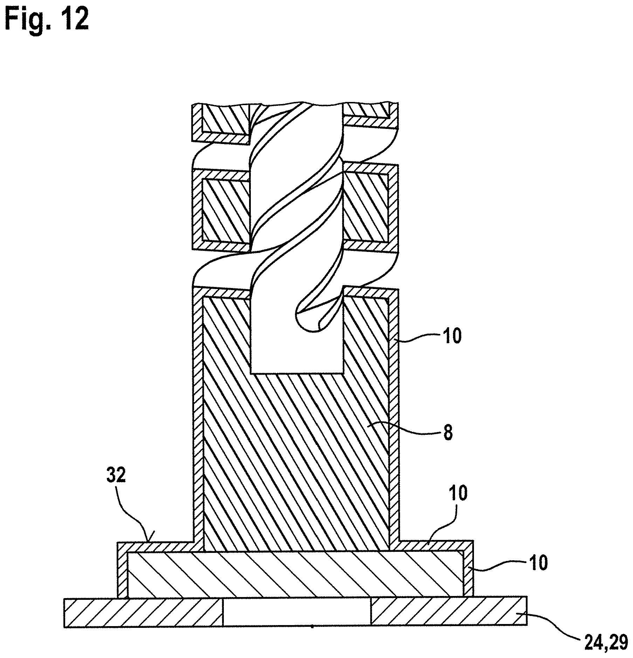

Die vorstehenden Ausführungen werden durch die Figuren 10 bis 12 nochmals verdeutlicht. In der Figur 10 ist erkennbar, dass das aus Kunststoff bestehende Basisteil 8 eines Federkontaktstifts 9 auf einer elektrischen Kontaktfläche 32 eines Verbindungsteils 24 im erfindungsgemäßen Verfahren hergestellt wird. Anschließend erfolgt - gemäß Figur 11 - das Metallisieren, wobei die metallische Beschichtung 10 auf das Basisteil 8 und auch auf die elektrische Kontaktfläche 32 aufgebracht ist, nicht jedoch auf die Oberfläche des Verbindungsteils 24. Anschließend kann - optional - das aus Kunststoff bestehende Basisteil 8 - wie erläutert - entfernt werden. Alternativ bleibt das Basisteil 8 im Innern des Federkontaktstifts 9 erhalten. Die Figur 12 verdeutlicht in ihrer Schnittansicht, dass die metallische Beschichtung 10 nicht nur auf dem Basisteil 8, sondern auch auf der Kontaktfläche 32 hergestellt wird. Die metallische Beschichtung 10 ist einstückig realisiert.

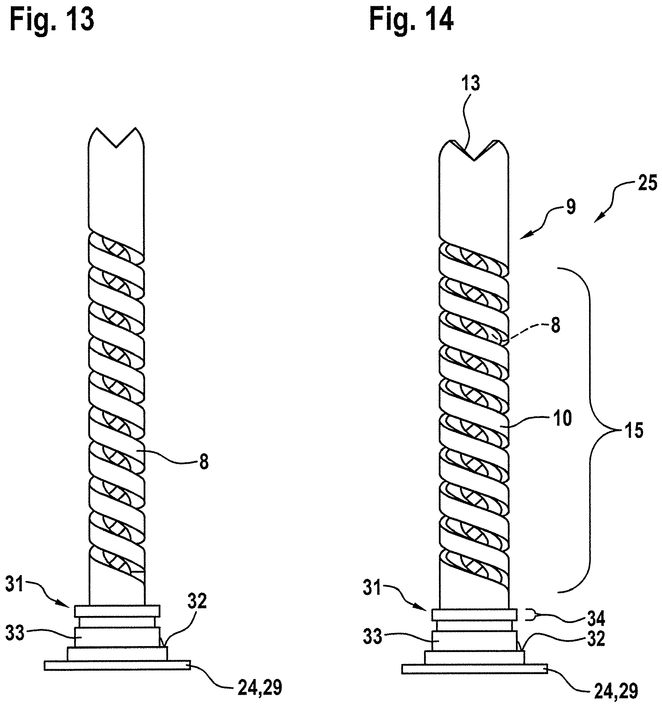

Die Figur 13 zeigt ein Ausführungsbeispiel der Erfindung, das dem Ausführungsbeispiel der Figur 10 entspricht, wobei jedoch zwischen der elektrischen Kontaktfläche 32 und dem Basisteil 8 ein Sockelbauteil 33, insbesondere aus elektrisch leitfähigem Material, angeordnet/erzeugt wird. Auf die Ausführungen zu den Figuren 9 bis 12 wird beim Ausführungsbeispiel der Figuren 13 und 14 Bezug genommen, wobei nachstehend nur die Unterschiede beim Ausführungsbeispiel der Figur 13 und 14 beschrieben werden. Das sich auf der Kontaktfläche 32 befindende Sockelbauteil 33 kann als Zuführteil dem erfindungsgemäßen Prozess zugeführt werden oder es wird in dem additiven Fertigungsverfahren miterstellt, mit dem auch das Basisteil 8 erstellt wird, wobei allerdings unterschiedliche Materialien zum Einsatz kommen, da das Basisteil 8 aus insbesondere elektrisch nicht leitendem Kunststoff besteht und das Sockelbauteil 33 vorzugsweise aus elektrisch leitfähigem Material. Ferner besteht die Möglichkeit, dass das Sockelbauteil 33 in dem bereits erwähnten weiteren additiven Fertigungsverfahren erstellt wird, insbesondere durch Sintern von mindestens einem Pulverwerkstoff. Die additiven Fertigungsschritte erfolgen vorzugsweise unmittelbar direkt auf dem elektrischen Schaltungsträger 29, insbesondere auf dessen elektrischer Kontaktfläche 32. Nachdem das Sockelbauteil 33 insbesondere im additiven Fertigungsverfahren hergestellt ist, erfolgt die Herstellung des Basisteils 8 des Federkontaktstifts 9 auf dem Sockelbauteil 33. Anschließend wird die metallische Beschichtung 10 aufgebracht, wobei das Basisteil 8 beschichtet wird und die metallische Beschichtung 10 auch auf einem an das Basisteil 8 angrenzenden Bereich 34 des Sockelbauteils 33 erstellt wird, nicht jedoch weitergehend in Richtung auf das Verbindungsteil 24, insbesondere nicht auf der Kontaktfläche 32. Hierdurch wird verhindert, dass es zu Kurzschlüssen zwischen den einzelnen Federkontaktstiften 9 kommt. Da das Sockelbauteil 33 aus elektrisch leitfähigem Material besteht, ist ein elektrischer Pfad von der metallischen Beschichtung 10 des Federkontaktstifts 9 zum Sockelbauteil 33 und von dort zur elektrischen Kontaktfläche 32 sichergestellt. Die erwähnte, nur teilweise erfolgende metallische Beschichtung des Sockelbauteils 33 kann insbesondere dadurch realisiert werden, dass die Baugruppe nur teilweise in einen Beschichtungs-Elektrolyten eingetaucht wird. Um eine gute Haftung zwischen der metallischen Beschichtung 10 und dem Sockelbauteil 33 sicherzustellen, ist es möglich, ein Sockelbauteil 33 mit entsprechenden Strukturen, zum Beispiel einstichartigen Strukturen zu verwenden oder herzustellen, wodurch sich ein Formschluss der Beschichtung 10 mit dem Sockelbauteil 33 ergibt.

Wie bereits erwähnt, ist es vorteilhaft, wenn das Sockelbauteil 33 mittels eines additiven Fertigungsverfahrens, insbesondere Mikrolasersinterns von metallischen Pulverwerkstoffen, auf der elektrischen Kontaktfläche 32 hergestellt wird. Hierdurch ergibt sich dabei eine gute Verbindung zwischen Sockelbauteil 33 und Kontaktfläche 32, die nicht nur mechanisch wirkt, sondern auch einen elektrischen Übergang darstellt. Besonders die erwähnte Technologie des Mikrolasersinterns ist hier vielversprechend, da eine stoffliche Vermischung (Verschweißung) der zwei unterschiedlichen Bauteil-Materialen realisiert wird.

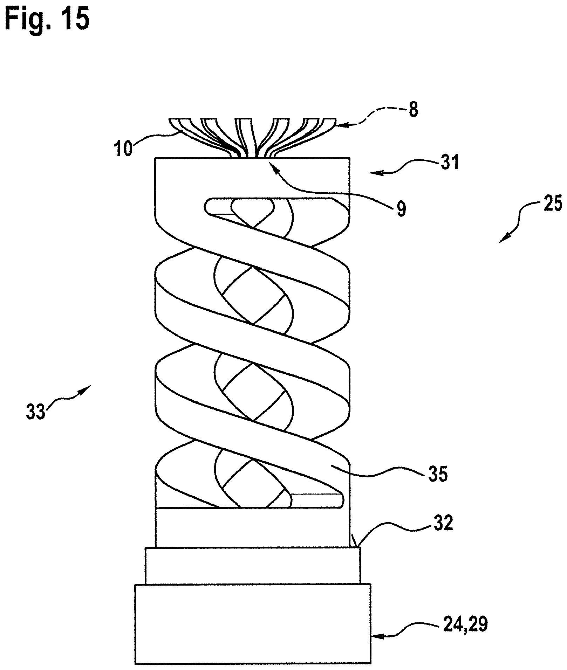

Die Figur 15 zeigt ein weiteres Ausführungsbeispiel einer Federkontaktstift-Anordnung 25. Die Ausgestaltung entspricht der Ausgestaltung der Figur 14, jedoch ist das Sockelbauteil 33 mit mindestens einer federnden Struktur 35 versehen/hergestellt, welche - zusätzlich zu dem Federkontaktstift 9 - eine zusätzliche axial elastische Verformbarkeit ermöglicht, was eine gute Berührungskontaktierung sicherstellt. Hinsichtlich des Sockelbauteils 33 der Figur 15 wird auf die vorhergehenden Ausführungen zum Sockelbauteil 33 der Figuren 13 und 14 entsprechend verwiesen. Der Federkontaktstift 9 der Figur 15 erschöpft sich im Wesentlichen in einer kopfartigen Federstruktur, die im erfindungsgemäßen Verfahren erstellt wird, also zunächst Herstellung des Basisteil 8 aus Kunststoff insbesondere auf dem Sockelbauteil 33 und dann nachfolgend die metallische Beschichtung, insbesondere des Basisteils 8 und bevorzugt ein Stückweit auf dem Sockelbauteil 33.

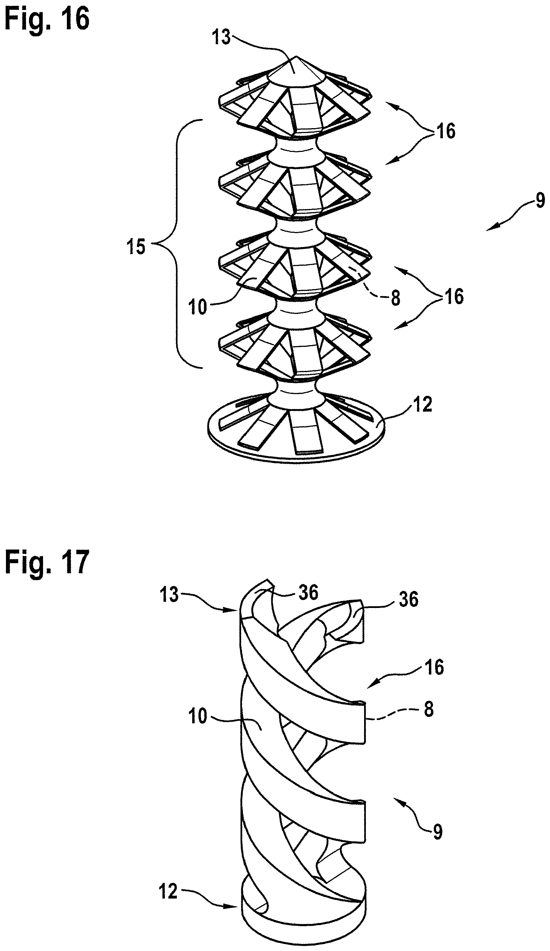

Die Figur 16 zeigt ein weiteres Ausführungsbeispiel eines Federkontaktstifts 9, hergestellt nachdem erfindungsgemäßen Verfahren. Um die Federwirkung des Federkontaktstifts 9 zu erzielen sind mehrere Federelement 16 in Reihe geschaltet, die tellerfederartig wirken, wobei das kopfseitige Federelement 16 gleichzeitig die Spitze 14 ausbildet.

Die Figur 17 zeigt ein weiteres Ausführungsbeispiel eines Federkontaktstifts 9, hergestellt nach dem erfindungsgemäßen Verfahren. Der Federkontaktstift 9 der Figur 17 besteht insbesondere aus zwei umeinander gewundene Wendel. Der die Berührungskontaktierung vornehmende Kopf wird von bogenförmigen Flächen 36 gebildet.

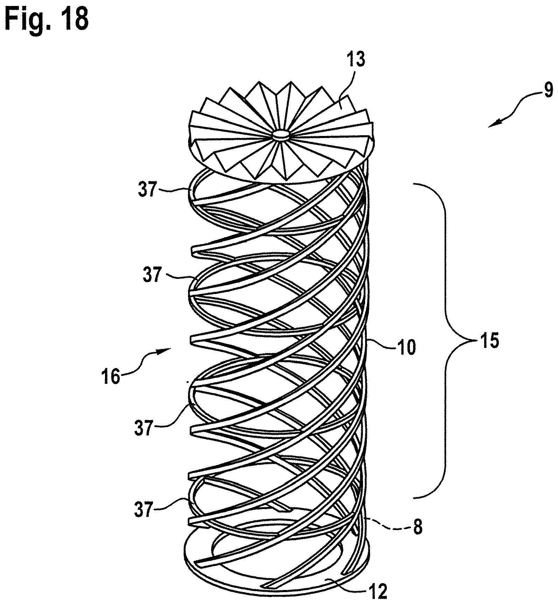

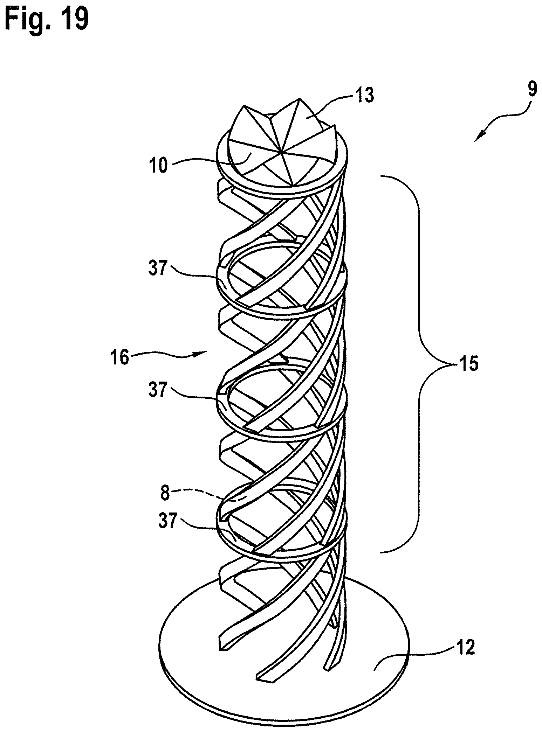

Die Figuren 18 und 19 zeigen weitere Federkontaktstifte 9, die nach dem erfindungsgemäßen Verfahren hergestellt sind, wobei der federnde Bereich 15 durch eine Mehrfachwendel gebildet ist. Zur Stabilisierung weist die Mehrfachwendel beabstandet zueinander liegende Stützringe 37 auf. Der Kopf 12 ist jeweils mittels einer Zahnrosette realisiert. Durch die Mehrfachwendel wird sich beim Einfedern der Struktur ein Drehmoment entwickeln, welches zu gewollten, geringfügigen "Beschädigungen" des Kontaktpartners führt und dadurch optimale Kontaktierungsergebnisse erbringt.

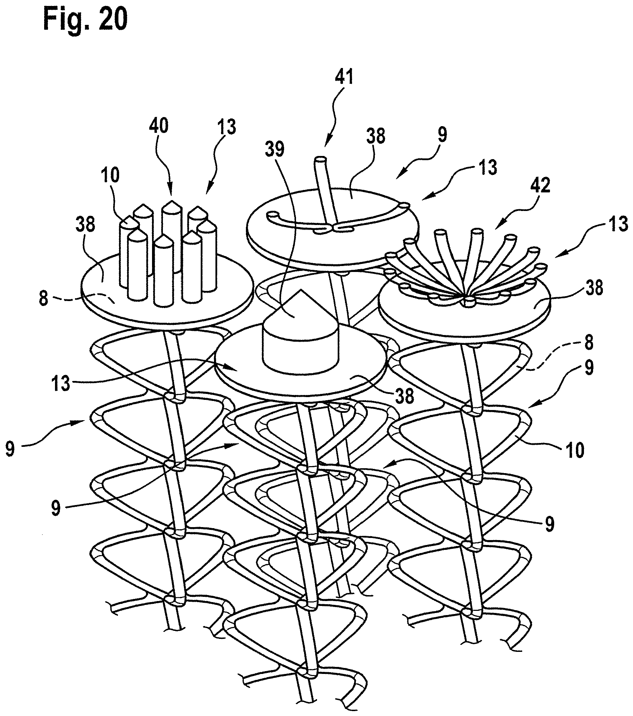

Die Figur 20 weist weitere Ausführungsbeispiele von Federkontaktstiften 9 auf, die unterschiedliche Kopfstrukturen besitzen. Wiederum erfolgt die Herstellung dieser Federkontaktstifte 9 mittels des erfindungsgemäßen Verfahrens. Der Kopf 12 weist jeweils einen Teller 38, auf dem eine Einfachspitze 39, eine Mehrfachspitze 40, eine Dreifingerkontur 41 oder eine Vielfachfingerkontur 42 (mehr als drei Finger) ausgebildet wird.

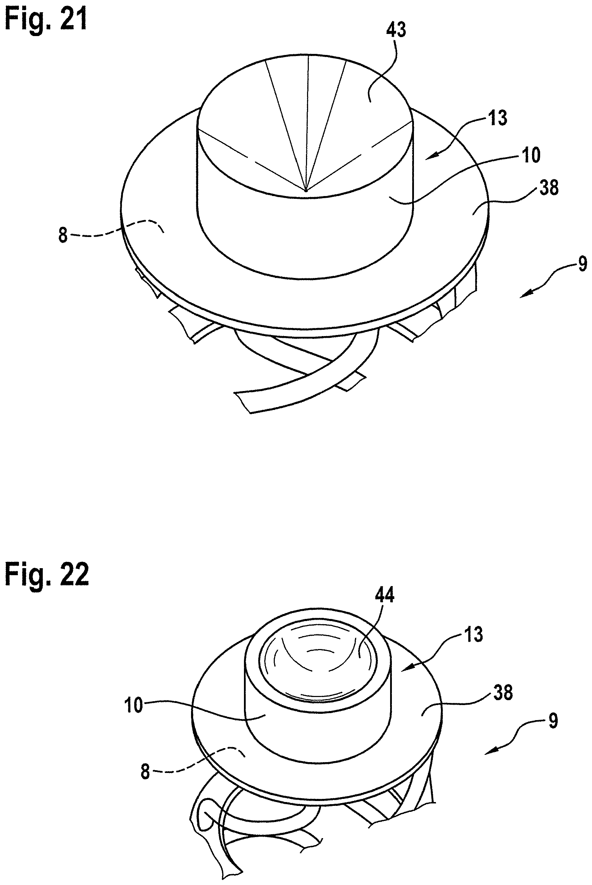

Die Figuren 21 und 22 zeigen zwei Köpfe 12, die optional jeweils einen Teller 38 aufweisen, auf dem eine mit scharfer Kante versehene Konusstruktur 43 (Figur 21) oder eine konkave Halbkugelstruktur 44 ausgebildet ist. Die Federkontaktstifte 9 der Figuren 21 und 22 können jeweils im nicht dargestellten Endbereich einen weiteren Vorsprung, insbesondere Teller oder dergleichen aufweisen. Es ist dann möglich, den Federkontaktstift zwischen zwei Führungsplatten anzuordnen, wie bereits beim Ausführungsbeispiel der Figur 7 beschrieben, wobei die beiden Teller oder dergleichen sich an den Innenseiten der beiden Führungsplatten abstützen.

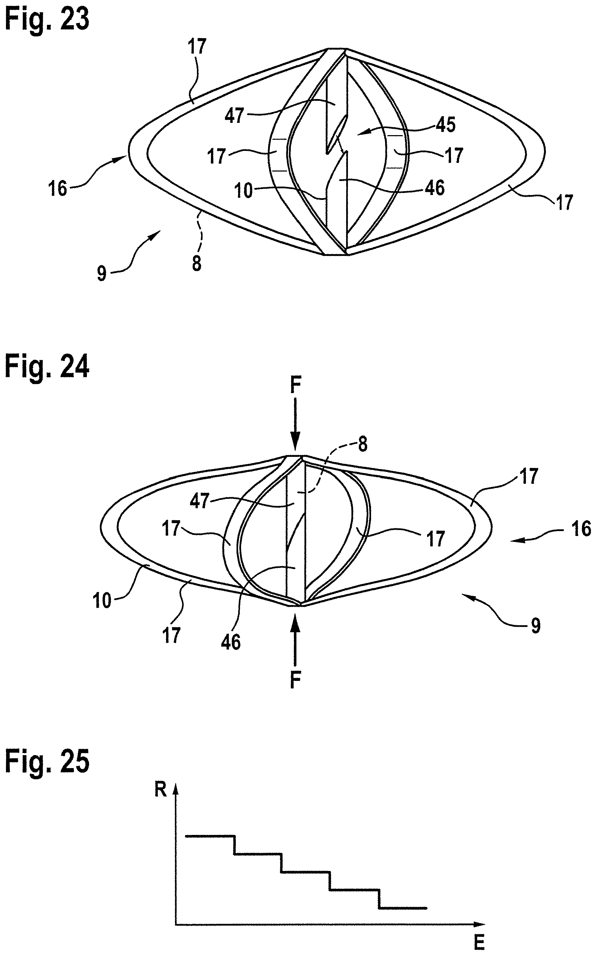

Die Figuren 23 bis 25 zeigen einen Federkontaktstift 9 oder einen Abschnitt eines Federkontaktstifts 9, jeweils hergestellt nach dem erfindungsgemäßen Verfahren. Die Anordnung ist derart getroffen, dass bei einer axialen Belastung (Kräfte F in Figur 24) ein Schaltkontakt 45 (unterbrochene Mittelsäule) geschlossen wird (Vergleich der Figuren 23 und 24). Zum Schließen des Schaltkontaktes 45 kommt es, wenn mit dem Federkontaktstift 9 eine elektrische Berührungskontaktierung eines Prüflings oder dergleichen vorgenommen wird. Da die aus den Figuren 23 und 24 ersichtlichen Federstrukturen (Arme 17) metallisiert sind, leiten sie elektrisch. Beim Schließen des Schaltkontakts 45 durch Zusammenfahren von zwei, einander gegenüberliegenden Kontaktstrukturen 46 und 47 der Mittelsäule wird der elektrische Widerstand der Anordnung herabgesetzt, d.h., es ergibt sich eine Stufe in der Kennlinie, so wie sie aus der Figur 25 ersichtlich ist. Dort ist der elektrische Widerstand R dargestellt über der Einpresstiefe E, also über den Weg des axialen Zusammendrückens des Federkontaktstifts 9. Wenn der Federkontaktstift 9 aus mehreren derartigen Strukturen gemäß Figur 23 besteht, die in Reihe zueinander geschaltet sind und wenn die Kontaktstrukturen 46 und 47 der einzelnen in Reihe geschalteten Elemente unterschiedlich große Abstände aufweisen (im nicht kontaktierten Zustand), dann ergibt sich das Diagramm der Figur 25, d.h., bei größer werdender Einpresstiefe E schließen mehr und mehr Schaltkontakte 45, mit der Folge, dass sich jeweils eine Stufe in der ersichtlichen Kennlinie einstellt.

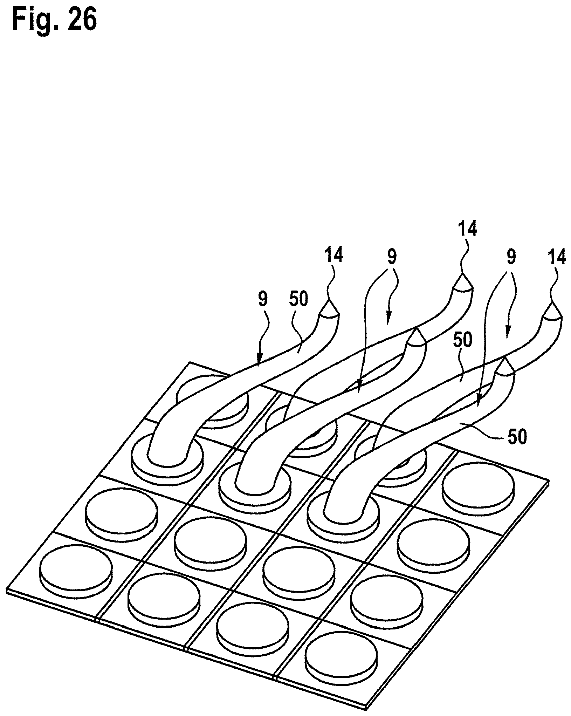

Die Figur 26 zeigt ein weiteres Ausführungsbeispiel, das vergleichbar ist mit dem zur Figur 9 beschriebenen Ausführungsbeispiel, sodass nachstehend nur auf die Unterschiede des Ausführungsbeispiels der Figur 26 gegenüber dem Ausführungsbeispiel der Figur 9 eingegangen wird. Grundsätzlich ist zunächst anzumerken, dass die Federkontaktstifte 9 der Figur 26 nicht entlang ihrer Mittelachsen axial federnd ausgebildet sind, sondern nach dem sogenannten Cantilever-Prinzip arbeiten, d.h., sie weisen seitlich auskragende Bereiche 50 auf und sie federn aufgrund dieser Bereiche 50. Insbesondere ist vorgesehen, dass die Federkontaktstifte 9 entlang ihrer Länge einen S-förmigen Verlauf aufweisen. Hierbei kann vorgesehen sein, dass sich der Durchmesser des jeweiligen Federkontaktstifts 9 in Richtung auf die Spitze 14 verjüngt. Auch hier ist vorgesehen, dass jeder Kontaktstift 9 ein Basisteil 8 aufweist, das mit einer metallischen Beschichtung 10 versehen ist. Bevorzugt wird hierfür das additive Fertigungsverfahren eingesetzt.

Die erfindungsgemäßen Federkontaktstifte 9 aller Ausführungsbeispiele können für die Berührungskontaktierung eines Prüflingskontakts allein verwendet werden oder es ist auch möglich, mehrere derartige Federkontaktstifte 9 parallel geschaltet zueinander für ein und denselben Prüflingskontakt zu verwenden, mit der Folge, dass dann die Kontaktierungskraft vergrößert ist, was sich positiv auf die elektrische Kontaktierung auswirken kann und ferner aufgrund der parallel geschalteten Stromwege eine sehr niederohmige Kontaktierung zur Folge hat.

## Patentansprüche

1. Verfahren zur Herstellung einer einer elektrischen Berührungskontaktierung dienenden Federkontaktstift-Anordnung mit mindestens einem Federkontaktstift, mit folgenden Schritten:
- Herstellen von mindestens einem Basisteil (8) des Federkontaktstifts (9), wobei mindestens ein Teil des Basisteils (8) aus Kunststoff hergestellt wird, und
- danach erfolgendem Metallisieren von mindestens dem aus Kunststoff bestehenden Teil des Basisteils (8), **dadurch gekennzeichnet, dass**
- die Herstellung von dem zumindest einen, aus Kunststoff bestehenden Teil des Basisteils (8) mittels additivem Fertigungsverfahren erfolgt und, dass
- der mindestens eine Federkontaktstift (9) auf einer elektrischen Kontaktfläche (32) eines als Schaltungsträger (29), insbesondere Leiterplatte (30), ausgebildeten Verbindungsteils (24) additiv aufgebaut wird.

2. Verfahren nach Anspruch 1, **dadurch gekennzeichnet, dass** als additives Fertigungsverfahren eine Zwei-Photonen-Laser-Lithografie, insbesondere ein Dip-In-Laser-Lithografieverfahren, eingesetzt wird.

3. Verfahren nach einem der vorhergehenden Ansprüche, **dadurch gekennzeichnet, dass** das Metallisieren in mindestens einem galvanischen und/oder chemischen Prozess erfolgt.

4. Verfahren nach einem der vorhergehenden Ansprüche, **dadurch gekennzeichnet, dass** das gesamte Basisteil (8) aus Kunststoff, bevorzugt mittels des additiven Fertigungsverfahrens, hergestellt, insbesondere als einstückiges Basisteil (8) hergestellt wird.

5. Verfahren nach einem der vorhergehenden Ansprüche, **dadurch gekennzeichnet, dass** das gesamte Basisteil (8) metallisiert wird.

6. Verfahren nach einem der vorhergehenden Ansprüche, **dadurch gekennzeichnet, dass** vor dem galvanischen Metallisieren eine elektrisch leitfähige Startschicht zumindest auf das aus Kunststoff bestehende Teil des Basisteils (8) aufgebracht oder auf der Oberfläche des Teils erzeugt wird.

7. Verfahren nach einem der vorhergehenden Ansprüche, **dadurch gekennzeichnet, dass** vor dem Metallisieren eine Keimschicht zumindest auf das aus Kunststoff bestehende Teil des Basisteils aufgebracht wird, insbesondere im Tauch- oder Plasmaverfahren aufgebracht, oder auf der Oberfläche des Teils erzeugt wird.

8. Verfahren nach einem der vorhergehenden Ansprüche, **dadurch gekennzeichnet, dass** nach dem Metallisieren das aus Kunststoff bestehende Teil nicht oder zumindest bereichsweise entfernt wird, insbesondere mittels eines Pyrolyseverfahrens, eines nasschemischen Verfahrens und/oder eines trockenchemischen Verfahrens entfernt wird.

9. Verfahren nach einem der vorhergehenden Ansprüche, **dadurch gekennzeichnet, dass** in einer durch das Metallisieren gebildeten Metallhülle mindestens eine Öffnung erzeugt oder belassen wird, die zum Entweichen von Pyrolyseprodukten dient und/oder einen Zugriff von mindestens einem nass- und/oder trockenchemischen Mittel beim Durchführen des nasschemischen und/oder trockenchemischen Verfahrens ermöglicht.

10. Verfahren nach einem der vorhergehenden Ansprüche, **dadurch gekennzeichnet, dass** für die Federfunktion des Federkontaktstifts (9) mindestens ein Bereich (15) des Federkontaktstifts (9) durch Eigenelastizität und/oder Formgebung seines Materials federnd nachgiebig ausgebildet wird.

11. Verfahren nach einem der vorhergehenden Ansprüche, **dadurch gekennzeichnet, dass** der federnde Bereich (15) einstückig mit dem übrigen Abschnitt des Federkontaktstifts (9) ausgebildet ist.

12. Verfahren nach einem der vorhergehenden Ansprüche, **dadurch gekennzeichnet, dass** der federnde Bereich (15) durch Ausbildung mindestens einer Druck-, Zug-, Biege- und/oder Torsionsfeder und/oder als nach dem Knickdraht-Prinzip nachgiebiger Bereich hergestellt wird.

13. Verfahren nach einem der vorhergehenden Ansprüche, **dadurch gekennzeichnet, dass** endseitig am Federkontaktstift (9) mindestens ein Kopf (12,13) für die Berührungskontaktierung ausgebildet wird, der vorzugsweise mindestens eine scharfe Spitze und/oder scharfe Kante für die Berührungskontaktierung erhält.

14. Verfahren nach einem der vorhergehenden Ansprüche, **dadurch gekennzeichnet, dass** mehrere Federkontaktstifte (9) - insbesondere in einem zwei- oder dreidimensionalen Raster - über das mindestens eine Verbindungsteil (24) zusammenhängend hergestellt werden.

15. Verfahren nach einem der vorhergehenden Ansprüche, **dadurch gekennzeichnet, dass** das Verbindungsteil (24) im additiven Fertigungsverfahren erzeugt oder miterzeugt wird.

16. Verfahren nach einem der vorhergehenden Ansprüche, **dadurch gekennzeichnet, dass** die elektrische Kontaktfläche (32) mit metallisiert wird.

17. Verfahren nach einem der vorhergehenden Ansprüche, **dadurch gekennzeichnet, dass** eine zwischen mindestens zwei Federkontaktstiften (9) bestehende Metallisierung für eine elektrische Isolation der beiden Federkontaktstifte (9) zueinander entfernt wird, insbesondere mittels Laser, fokussierenden lonenstrahl und/oder Maskieren sowie Entfernen mittels Ätzen (Lift-Off).

18. Verfahren nach einem der vorhergehenden Ansprüche, **dadurch gekennzeichnet, dass** auf der Kontaktfläche (32) des Verbindungsteils (24) ein Sockelbauteil (33) aus elektrisch leitfähigem Material, vorzugsweise Metall, hergestellt/befestigt wird und dass auf dem Sockelbauteil (33) der Federkontaktstift (9) hergestellt wird, wobei das Metallisieren sich bis auf einen an das Basisteil (8) angrenzenden Bereich des Sockelbauteils (33) erstreckend erfolgt, jedoch nicht sich bis auf die Kontaktfläche (32) erstreckend erfolgt.

19. Verfahren nach einem der vorhergehenden Ansprüche, **dadurch gekennzeichnet, dass** das Sockelbauteil (33) im additiven Fertigungsverfahren, insbesondere durch Sintern, vorzugsweise Lasersintern, von Pulverwerkstoffen, hergestellt wird.

20. Verfahren nach einem der vorhergehenden Ansprüche, **dadurch gekennzeichnet, dass** die Herstellung des Sockelbauteils (33) auf der Kontaktfläche und insbesondere mit dieser elektrisch verbindend erfolgt.

21. Verfahren nach einem der vorhergehenden Ansprüche, **dadurch gekennzeichnet, dass** das Sockelbauteil (33) mit mindestens einer federnden Struktur, insbesondere einem federnden Bereich des insbesondere einstückigen Sockelbauteils (33), derart hergestellt wird, dass die Federwirkung in Richtung der Berührungskontaktierung wirksam ist.

## Claims

1. A method for manufacturing a spring contact pin assembly having at least one spring contact pin, for establishing physical electrical contact, the method comprising the following steps:
- manufacturing at least one base piece (8) of the spring contact pin (9), wherein at least a part of the base piece (8) is made of plastic, and
- subsequently metallising at least the part of the base piece (8) that is made of plastic, **characterised in that**
- manufacturing the at least one part of the base piece (8) that is made of plastic is carried out by means of an additive production process, and **in that**
- the at least one spring contact pin (9) is additively built on an electrical contact surface (32) of a connection piece (24) configured as a circuit carrier (29), in particular as a circuit board (30).

2. The method according to claim 1, **characterised in that** a two-photon laser lithography, in particular a dip-in laser lithography process is utilised as the additive production process.

3. The method according to any one of the preceding claims, **characterised in that** the metallisation is carried out in at least one galvanic and/or chemical process.

4. The method according to any one of the preceding claims, **characterised in that** the whole base piece (8) is made of plastic, preferably by means of the additive production process, in particular as a one-piece base piece (8).

5. The method according to any one of the preceding claims, **characterised in that** the whole base piece (8) is metallised.

6. The method according to any one of the preceding claims, **characterised in that** before the galvanic metallisation, an electrically conductive starter layer is applied at least to the part of the base piece (8) that is made of plastic, or is produced on the surface of the part.

7. The method according to any one of the preceding claims, **characterised in that**, before metallisation, a seed layer is applied at least to the part of the base piece that is made of plastic, in particular by the dipping or plasma process, or is produced on the surface of the part.

8. The method according to any one of the preceding claims, **characterised in that** after metallisation the part made of plastic is not removed or at least certain regions are removed, particularly removed by a pyrolysis process, a wet chemical process and/or a dry chemical process.

9. The method according to any one of the preceding claims, **characterised in that** at least one aperture is produced or left in a metal coating produced by the metallisation, the aperture serving for the venting of pyrolysis products and/or allowing the entry of at least one wet and/or dry chemical agent during execution of the wet chemical and/or dry chemical process.

10. The method according to any one of the preceding claims, **characterised in that** for the spring function of the spring contact pin (9) at least one region (15) of the spring contact pin (9) is configured in a spring-elastic manner due to its inherent elasticity and/or the shaping of its material.

11. The method according to any one of the preceding claims, **characterised in that** the spring-elastic region (15) is formed as one piece with the remaining portion of the spring contact pin (9).

12. The method according to any one of the preceding claims, **characterised in that** the spring-elastic region (15) is manufactured by forming at least one pressure, tension, bending and/or torsion spring and/or as a resilient area according to the buckling-wire principle.

13. The method according to any one of the preceding claims, **characterised in that** at least one head (12, 13) for physical contacting is formed on the end of the spring contact pin (9), the head preferably featuring at least one sharp tip and/or sharp edge for physical contacting.

14. The method according to any one of the preceding claims, **characterised in that** a plurality of spring contact pins (9) are produced in a manner connected by the at least one connecting piece (24), in particular in a two or three-dimensional grid.

15. The method according to any one of the preceding claims, **characterised in that** the connecting piece (24) is produced or co-produced by the additive production process.

16. The method according to any one of the preceding claims, **characterised in that** the electric contact surface (32) is also metallised.

17. The method according to any one of the preceding claims, **characterised in that** a metallisation present between at least two spring contact pins (9) is removed, particularly by laser, focusing ion beam and/or masking as well as by etching (lift-off), to electrically isolate the two spring contact pins (9) from each another.

18. The method according to any one of the preceding claims, **characterised in that** a pedestal component (33) made of electrically conductive material, preferably of metal, is produced on/attached to the contact surface (32) of the connecting piece (24), and that the spring contact pin (9) is produced on the pedestal component (33), wherein the metallisation is performed up to an area of the pedestal component (33) adjacent to the base piece (8), but is not extended to the contact surface (32).

19. The method according to any one of the preceding claims, **characterised in that** the pedestal component (33) is manufactured in the additive production process, in particular by sintering, preferably laser sintering, of powder materials.

20. The method according to any one of the preceding claims, **characterised in that** the manufacturing of the pedestal component (33) is carried out on the contact surface and in particular in a manner establishing an electrical contact therewith.

21. The method according to any one of the preceding claims, **characterised in that** the pedestal component (33) is manufactured with at least one spring-elastic structure, in particular a spring-elastic area of the particularly one-piece pedestal component (33), in such a manner that the spring effect acts in the direction of the physical contacting.

## Revendications

1. Procédé pour fabriquer un arrangement de tige de contact à ressort servant à la connexion électrique par contact physique, l'arrangement ayant au moins une tige de contact à ressort, le procédé comprenant les étapes suivantes consistant à :
- fabriquer au moins une pièce de base (8) de la tige de contact à ressort (9), au moins une partie de la pièce de base (8) étant fabriquée en matière plastique, et
- ensuite métalliser au moins la partie en matière plastique de la pièce de base (8), **caractérisé en ce que**
- la fabrication de la au moins une partie en matière plastique de la pièce de base (8) est effectuée au moyen d'un procédé de production additif, et **en ce que**
- la au moins une tige de contact à ressort (9) est construite de manière additive, sur une surface de contact électrique (32) d'une pièce de connexion (24) configurée sous forme d'un support de circuit (29), notamment d'une carte de circuit (30).

2. Procédé selon la revendication 1, **caractérisé en ce qu'**une lithographie laser à deux photons, en particulier un procédé de lithographie laser par immersion, est utilisée en tant que procédé de production additif

3. Procédé selon l'une quelconque des revendications précédentes, **caractérisé en ce que** la métallisation est effectuée par au moins un procédé galvanique et/ou chimique.

4. Procédé selon l'une quelconque des revendications précédentes, **caractérisé en ce que** l'ensemble de la pièce de base (8) est fabriqué en matière plastique, de préférence au moyen du procédé de production additif, en particulier en tant que pièce de base (8) en une seule pièce.

5. Procédé selon l'une quelconque des revendications précédentes, **caractérisé en ce que** l'ensemble de la pièce de base (8) est métallisé.

6. Procédé selon l'une quelconque des revendications précédentes, **caractérisé en ce qu'**une couche de départ conductrice de l'électricité est appliquée au moins sur la partie en matière plastique de la pièce de base (8), ou est produite sur la surface de la partie avant la métallisation galvanique.

7. Procédé selon l'une quelconque des revendications précédentes, **caractérisé en ce qu'**avant la métallisation, une couche de semence est appliquée, en particulier par un procédé d'immersion ou de plasma, au moins sur la partie en matière plastique de la pièce de base, ou est produite sur la surface de la partie.

8. Procédé selon l'une quelconque des revendications précédentes, **caractérisé en ce qu'**après la métallisation, la partie en matière plastique n'est pas enlevée ou est au moins partiellement enlevée, en particulier par un procédé de pyrolyse, un procédé chimique humide et/ou un procédé chimique sec.

9. Procédé selon l'une quelconque des revendications précédentes, **caractérisé en ce qu'**au moins une ouverture est produite ou laissée dans une enveloppe métallique formée par la métallisation, l'ouverture servant à décharger des produits de pyrolyse et/ou permettre l'entrée d'au moins un agent chimique humide et/ou sec lors de l'exécution du procédé chimique humide et/ou sec.

10. Procédé selon l'une quelconque des revendications précédentes, **caractérisé en ce que**, pour la fonction ressort de la tige de contact à ressort (9), au moins une région (15) de la tige de contact à ressort (9) est configurée de manière élastique par l'élasticité inhérente et/ou par la forme de son matériau.

11. Procédé selon l'une quelconque des revendications précédentes, **caractérisé en ce que** la région élastique (15) est formée d'une seule pièce avec la partie restante de la tige de contact à ressort (9).

12. Procédé selon l'une quelconque des revendications précédentes, **caractérisé en ce que** la région élastique (15) est produite par formation d'au moins un ressort de compression, de traction, de flexion et/ou de torsion et/ou en tant que zone flexible selon le principe du « fil de flambement ».

13. Procédé selon l'une quelconque des revendications précédentes, **caractérisé en ce qu'**au moins une tête (12, 13) est formée à l'extrémité de la tige de contact à ressort (9) pour la connexion électrique par contact physique, la tête ayant de préférence au moins une pointe et/ou une arête vive pour la connexion électrique par contact physique.

14. Procédé selon l'une quelconque des revendications précédentes, **caractérisé en ce que** plusieurs tiges de contact à ressort (9) - en particulier dans une grille bidimensionnelle ou tridimensionnelle - sont fabriquées de manière à être reliées entre elles par la au moins une pièce de connexion (24).

15. Procédé selon l'une quelconque des revendications précédentes, **caractérisé en ce que** la pièce de connexion (24) est fabriquée ou fabriquée simultanément par le procédé de production additif.

16. Procédé selon l'une quelconque des revendications précédentes, **caractérisé en ce que** la surface de contact électrique (32) est aussi métallisée.

17. Procédé selon l'une quelconque des revendications précédentes, **caractérisé en ce qu'**une métallisation entre au moins deux tiges de contact à ressort (9) est éliminée, en particulier au moyen d'un laser, d'un faisceau d'ions de focalisation et/ou d'un masque ainsi que par enlèvement au moyen de décapage (« lift-off »), pour isoler électriquement deux tiges de contact à ressort (9) l'une par rapport à l'autre.

18. Procédé selon l'une quelconque des revendications précédentes, **caractérisé en ce qu'**un composant de base (33) en matériau conducteur d'électricité, de préférence en métal, est produit/fixé sur la surface de contact (32) de la pièce de connexion (24), et **en ce que** la tige de contact à ressort (9) est fabriquée sur le composant de base (33), la métallisation s'effectuant jusqu'à une région du composant de base (33) adjacente à la pièce de base (8), mais ne s'étendant pas jusqu'à la surface de contact (32).

19. Procédé selon l'une quelconque des revendications précédentes, **caractérisé en ce que** le composant de base (33) est fabriqué par un procédé de production additif, en particulier par frittage, de préférence par frittage par laser, à partir de matériaux en poudre.

20. Procédé selon l'une quelconque des revendications précédentes, **caractérisé en ce que** la fabrication du composant de base (33) est effectuée sur la surface de contact et notamment de manière à établir le contact physique avec celle-ci.

21. Procédé selon l'une quelconque des revendications précédentes, **caractérisé en ce que** le composant de base (33) est réalisé avec au moins une structure élastique, en particulier une zone élastique du composant de base (33) en particulier en une seule pièce, de telle sorte que l'action du ressort est efficace dans la direction du contact physique.
